Europäisches Patentamt

European Patent Office

Office européen des brevets

(19)

(11) EP 0 613 017 B1

(12) # FASCICULE DE BREVET EUROPEEN

(45) Date de publication et mention
de la délivrance du brevet:
**27.05.1998  Bulletin 1998/22**

(51) Int Cl.⁶: **G01R 15/24**

(21) Numéro de dépôt: **94400361.5**

(22) Date de dépôt: **18.02.1994**

(54) **Dispositif optique pour la mesure de l'intensité du courant électrique**

Vorrichtung zur optischen Messung der elektrischen Stromstärke

Device for optically measuring current intensity

(84) Etats contractants désignés:
**BE CH DE ES FR GB IT LI NL SE**

(30) Priorité:  **22.02.1993  FR 9301991**

(43) Date de publication de la demande:
**31.08.1994   Bulletin 1994/35**

(73) Titulaire: **GEC ALSTHOM T & D BALTEAU
92120 Montrouge (FR)**

(72) Inventeur: **Chatrefou, Denis
F-91860 Epinay sous Senart (FR)**

(74) Mandataire: **Fournier, Michel
c/o ALCATEL ALSTHOM,
Département de Propriété Industrielle,
30, avenue Kléber
75116 Paris (FR)**

(56) Documents cités:
**EP-A- 0 089 275**          **EP-A- 0 477 415**

- **PATENT ABSTRACTS OF JAPAN vol. 8, no. 137
  (P-282) (1574) 26 Juin 1984 & JP-A-59 037 461
  (HITACHI) 29 Février 1984**
- **PATENT ABSTRACTS OF JAPAN vol. 13, no. 250
  (P-882) 12 Juin 1989 & JP-A-01 049 973 (TOKYO
  ELECTRIC POWER) 27 Février 1989**

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

**Description**

La présente invention concerne la mesure de l'intensité d'un courant électrique au moyen d'un dispositif optique faisant application de l'effet Faraday et du théorème d'Ampère.

L'effet Faraday traduit la proportionnalité de l'angle $\Theta f$ de rotation du plan de polarisation d'une lumière monochromatique, linéairement polarisée, traversant un milieu optique homogène au champ magnétique auquel le milieu est soumis.

Le théorème d'Ampère transforme une mesure de champ magnétique en une mesure d'intensité par intégration du phénomène sur un contour fermé entourant un conducteur traversé par le courant électrique à mesurer.

Le théorème d'Ampère peut être mis en oeuvre soit en faisant passer la lumière dans une fibre optique agencée en boucle fermée entourant le conducteur électrique, soit en la faisant passer dans un anneau de verre ou autre milieu transparent (dénommé en langue anglaise "Ring-glass") muni d'un trou central traversé par le conducteur et usiné de manière à faire décrire à la lumière, par une série de réflexions totales à 45°, un contour fermé. C'est de cette deuxième solution dont il est question dans la présente demande de brevet.

Comme on l'a dit plus haut, l'effet Faraday est un effet de polarisation qui nécessite l'emploi d'un polariseur d'entrée et d'un analyseur de sortie.

On rappelle que si le polariseur et l'analyseur sont croisés à 45° l'un de l'autre et si, de plus, l'analyseur de sortie est un séparateur de polarisation, on obtient deux signaux optiques I1 et I2 qui s'expriment en première approximation par les relations suivantes:

$$I1 = \frac{Io}{2}\ (1 + \sin 2\Theta f)$$

$$I2 = \frac{Io}{2}\ (1 - \sin 2\Theta f)$$

dans lesquelles Io est l'intensité lumineuse traversant le système optique, généralement fournie par exemple par une diode laser, ou toute autre source de lumière quasi- monochromatique.

Ces signaux sont transportés, généralement par fibres optiques, jusqu'à un appareil de conversion et de traitement électronique qui restitue, sous la forme désirée, la variable $\Theta f$ qui est une image du courant à mesurer.

La principale difficulté rencontrée dans la réalisation des dispositifs optiques à anneau de verre pour la mesure, avec une grande précision, de l'intensité d'un courant électrique, est celui de la stabilité avec la température. De tels appareils sont en effet placés dans des conditions climatiques très changeantes et la température ambiante peut varier dans une large gamme de valeur.

Il a été proposé, dans le document EP-A-477 415, de réaliser un transformateur de courant optique comprenant un substrat dans lequel un guide d'onde, entourant le courant à mesurer, est réalisé de manière intégrée et enterrée dans le substrat. Il est mentionné dans le document que d'autres éléments du dispositif de mesure, tels que des polariseurs, un miroir ou un coupleur en Y peuvent également être intégrés dans le substrat, de telle sorte que le dispositif est insensible aux influences extérieures telles que les variations de température et les vibrations.

Un tel dispositif est de réalisation difficile et coûteuse, puisque le guide d'onde et les éléments sont réalisés par exemple par remplacement dans un substrat de verre des ions Na+ par des ions Ag+. Par ailleurs, le document ne montre pas comment les fibres optiques d'amenée et de départ de lumière sont fixées au substrat, ce qui est un des problèmes les plus difficiles à résoudre dans cette technique, pour éviter l'influence des variations de température et des vibrations.

Un but de la présente invention est de réaliser un dispositif permettant d'effectuer des mesures avec une température ambiante pouvant varier de -60°C à +60°C, tout en restant dans une classe donnée de précision.

Un autre but de l'invention est de réaliser un dispositif de réalisation plus économique que celle des dispositifs de l'art antérieur.

Un autre but de l'invention est de réaliser un dispositif à anneau de verre dans lequel la liaison entre l'anneau de verre et les fibres d'amenée et de départ de lumière est réalisée par des moyens qui la rendent insensible aux variations de température et aux vibrations.

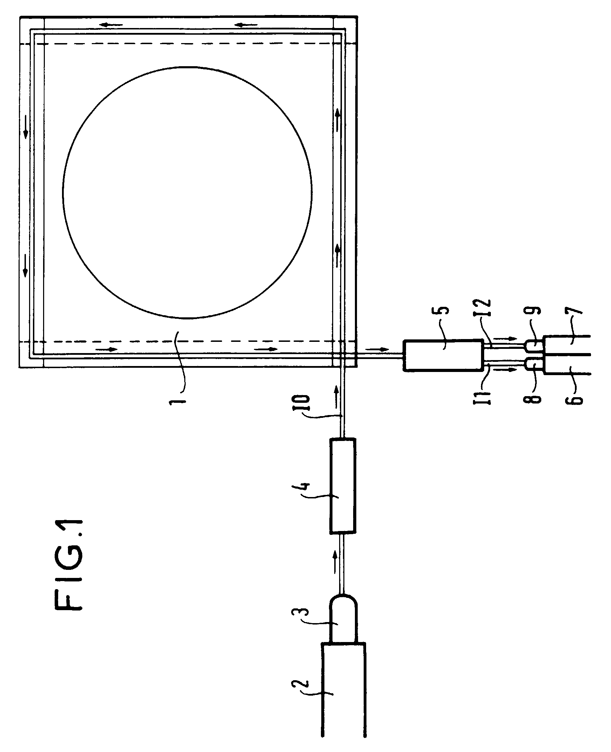

Pour bien comprendre les difficultés dues aux variations de température, on se référera à la figure 1, représentant schématiquement un dispositif optique à anneau de verre de l'art antérieur, et comprenant:

- un anneau de verre 1 traversé par le conducteur non représenté dont on mesure le courant,
- une fibre optique 2 alimentée en lumière, par exemple par une diode laser non représentée, ou toute autre source quasi-monochromatique, et munie d'une lentille d'extrémité 3 (le faisceau de lumière incidentes est désigné par Io),
- un polariseur d'entrée 4,
- un analyseur de sortie 5 fournissant en sortie deux faisceaux de lumière I1 et I2 (un faisceau dit ordinaire et un faisceau dit extraordinaire),
- deux fibres optiques 6 et 7, munies respectivement de lentilles 8 et 9, pour acheminer les signaux vers un dispositif de conversion et de traitement électronique non représenté.

Une première cause d'imprécision dans les mesures faites avec les dispositifs de l'art antérieur résulte du fait que des dispositifs sont nécessaires pour solidariser l'anneau de verre et le polariseur d'une part, l'analyseur d'autre part. Ces dispositifs sont en effet sujets à des dilatations différentes de celle de l'anneau de verre, de sorte que l'ensemble se modifie avec la température.

Selon une caractéristique de l'invention, le polariseur, l'analyseur et les connecteurs de fibres optiques sont directement fixés à l'anneau par une colle souple non traversée par le faisceau lumineux.

Une réalisation possible est de fixer lesdits composants dans une ou deux cavités usinées dans l'anneau. De la sorte, toute variation de température est ressentie de la même manière par les divers éléments du dispositif et toute conséquence qui serait due à une dilatation différentielle est supprimée.

Une autre cause d'erreur du dispositif de l'art antérieur, due aux variations de température, résulte des considérations ci-après.

Les signaux réels, issus de l'analyseur, s'écrivent:

$$I1 = To\ T1\ \frac{Io}{2}(1 + sin2\Theta f)$$

$$I2 = To\ T2\ \frac{Io}{2}(1 - sin2\Theta f)$$

où T0, T1 et T2 ont les significations ci-dessous:

T0 représente la transmission du système commun aux deux faisceaux de sortie I1 et I2,
T1 et T2 représentent les transmissions respectives, différentes, des faisceaux I1 et I2.
Il est possible, par un traitement électronique tel que celui décrit dans le brevet français FR-A-2 686 422 déposé le 22 janvier 1992 au nom du Demandeur et ayant pour titre "Dispositif de traitement de signaux issus d'un capteur optique à effet Faraday" :

1° de rendre T1 = T2 = T12 par un asservissement entre voies basé sur un principe d'intégration,
2° de s'affranchir du terme ToT12Io en effectuant la division $\frac{I1 - I2}{I1 + I2}$.

Mais du fait que la précision finale dépend du nombre de bits choisis pour la numérisation, il faut que la variation possible de ToT12Io soit la plus faible possible.

Le terme Io est proportionnel à la puissance de la source émettrice; cette puissance est aisément stabilisée en puissance électrique et en température.

C'est donc le terme ToT12 qu'il faut stabiliser le mieux possible.

Comme on l'a vu en décrivant la figure 1, le faisceau optique doit être collimaté (c'est-à-dire rendu sensiblement parallèle) avant d'entrer dans le polariseur 4; de mêmes les faisceaux quittant l'analyseur 5 doivent être focalisés avant d'entrer dans les fibres 6 et 7; ceci est obtenu à l'aide de lentilles 3, 8 et 9.

Lorsque la température varie, l'indice et la forme des lentilles varient, ce qui entraîne des défocalisations des faisceaux; par ailleurs, la fluctuation de direction du faisceau extraordinaire dans le séparateur est d'autant plus grande que la séparation exigée est grande; or on a besoin, compte tenu de la dimension des lentilles 8 et 9, de pouvoir écarter de manière notable les faisceaux I1 et I2.

Pour toutes ces raisons, selon une autre caractéristique de la présente invention, les fibres utilisées pour les signaux de sortie sont de préférence des fibres "multimodes", dont la dimension du diamètre coeur peut être ajustée pour éliminer les lentilles 8 et 9.

D'autres caractéristiques et avantages de l'invention apparaîtront à la lecture de la description ci-après d'un mode de réalisation de l'invention, en référence au dessin annexé dans lequel:

- la figure 1 est un schéma d'un dispositif optique à anneau de verre selon l'art antérieur,
- la figure 2 est une vue de dessus d'un dispositif optique selon un premier mode de réalisation de l'invention,
- la figure 3 est une vue en élévation du même dispositif,
- la figure 4 est une vue de côté du même dispositif,
- la figure 5 est une vue de dessus d'un dispositif optique selon une variante de réalisation de l'invention,
- la figure 6 est une vue de côté du dispositif précédent,
- la figure 7 est une vue de dessus d'un dispositif optique à anneau de verre selon une autre variante de réalisation de l'invention.

La figure 1 a déjà été commentée et on n'y reviendra pas.

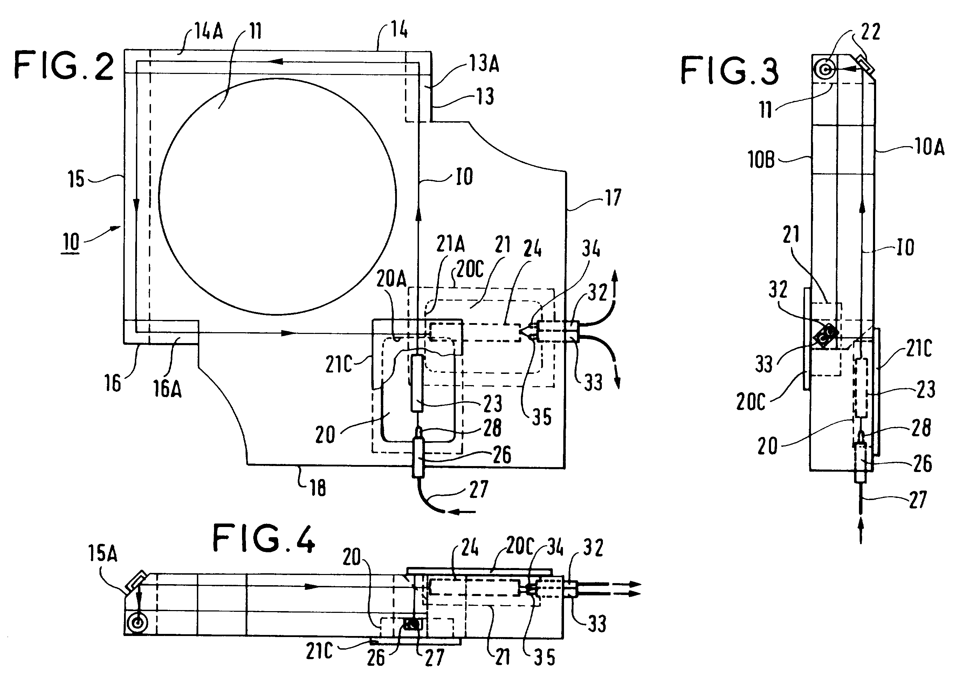

Dans les figures 2 à 4, on a représenté un anneau 10, usiné, servant d'élément sensible pour un dispositif optique de mesure de courant électrique. Le matériau de l'anneau est choisi en fonction de la sensibilité désirée qui dépend de la valeur de la constante de Verdet du matériau. A titre d'exemple, ce peut être de la silice ou du verre ou tout autre matériau transparent, homogène et isotrope.

L'anneau présente deux faces planes parallèles 10A et 10B, et une ouverture 11 à travers laquelle on fait passer le conducteur, non représenté, dont on désire mesurer le courant. L'anneau comprend quatre bords 13, 14, 15 et 16, perpendiculaires deux à deux et biseautés à 45°, les faces des biseaux étant référencées 13A, 14A, 15A et 16A; les bords sont disposés de manière à définir un contour rectangulaire (ou carré). La surface de l'anneau se prolonge du côté des bords 13 et 16 par une excroissance délimitée d'une part par deux côtés perpendiculaires non biseautés 17 et 18 respectivement parallèles aux bords 13 et 16, et d'autre part par des raccordements, non référencés, aux bords 13 et 16. Cette surface supplémentaire permet de fournir de la place à deux cavités 20 et 21 dans lesquelles sont logés respectivement un polariseur 23 et un analyseur 24.

La cavité 20 est ouverte sur la face 10A de l'anneau tandis que la cavité 21 s'ouvre sur la face 10B.

Le polariseur 23 est un barreau massif parallélépipédique de spath d'Islande, orienté perpendiculairement au bord 14, et collé au fond de la cavité 20 au moyen d'une colle souple. Une ouverture cylindrique relie l'intérieur de la cavité 20 au bord 18; cette ouverture sert à recevoir un embout 26 comprenant une fibre optique 27 terminée par une lentille 28; la fibre est reliée à une diode laser émettant une lumière monochromatique qui atteint une entrée du polariseur 23; en sortie du polariseur 23, la lumière polarisée, dont le trajet est représenté par le trait lo, pénètre dans le barreau par la paroi 20A de la cavité qui est parallèle au bord 14; la lumière subit des rélexions successives sur les bords 14, 15 et 16 et pénètre dans la cavité 21 par le bord 21A qui est parallèle au bord 15; la lumière pénètre dans le l'analyseur 24, qui est un barreau massif de spath d'Islande orienté perpendiculairement au bord 15, incliné à 45° par rapport au polariseur 23, et collé au fond de la cavité 21 par une colle souple. La cavité 21 communique avec le bord 17 du barreau par des ouvertures cylindriques dans lesquelles sont engagés des embouts à fibre optique à 32 et 33 munis respectivement de lentilles d'entrée 34 et 35.

On observe que le théorème d'Ampère est complètement respecté puisque la lumière décrit exactement un contour fermé dans le champ magnétique du conducteur.

Les cavités 20 et 21 peuvent être avantageusement remplies de gaz inerte sec et fermées chacune de manière étanche par un couvercle (respectivement 20C et 21C), réalisé dans le même matériau que celui de l'anneau.

De la même façon, la surface extérieure de l'anneau, aux points d'impact du faisceau lumineux sur les surfaces biseautées, est protégée par une coupelle de protection étanche 22 réalisée dans le même matériau que celui de l'anneau.

De la sorte, toutes les difficultés qui étaient dues aux dilatations différentielles sont supprimées. Dans le cas où le polariseur ou l'analyseur ont des coefficients de dilatation différents de celui du matériau de l'anneau, la dilatation différentielle est absorbée par la colle de fixation et le trajet de la lumière n'est pas modifié.

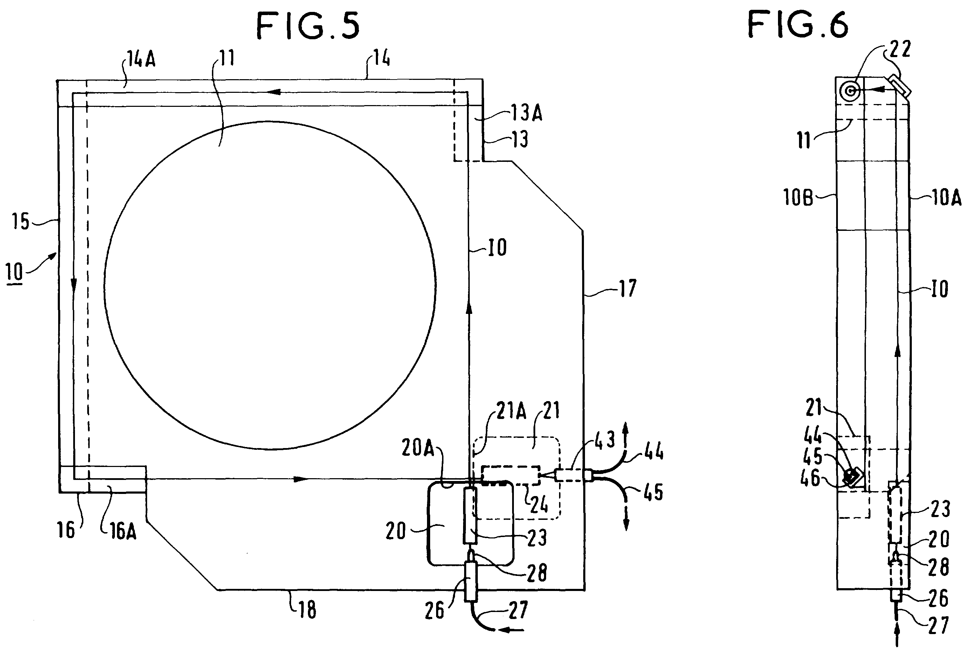

Les figures 5 et 6 représentent une variante de réalisation de l'invention; les éléments communs à ces figures et aux figures 2 à 4 ont reçu les mêmes numéros de référence.

Dans cette variante, l'analyseur 24 est toujours un barreau de spath monobloc orienté à 45° par rapport au polariseur 23; il repose par exemple sur un support prismatique 46. L'embout de sortie 43 contient deux fibres 44 et 45, multimodes, de plus grand diamètre que dans le cas précédent, disposées dans l'alignement de l'analyseur 24.

Compte tenu de la puissance directement couplée dans ces grosses fibres ( de valeurs typiques comprise entre 50 et 400 µm), il est possible de supprimer les deux lentilles de sortie, ce qui contribue encore à la stabilité thermique du dispositif, car nous supprimons les lentilles, sujettes à variations, et le filet de colle nécessaire à les fixer.

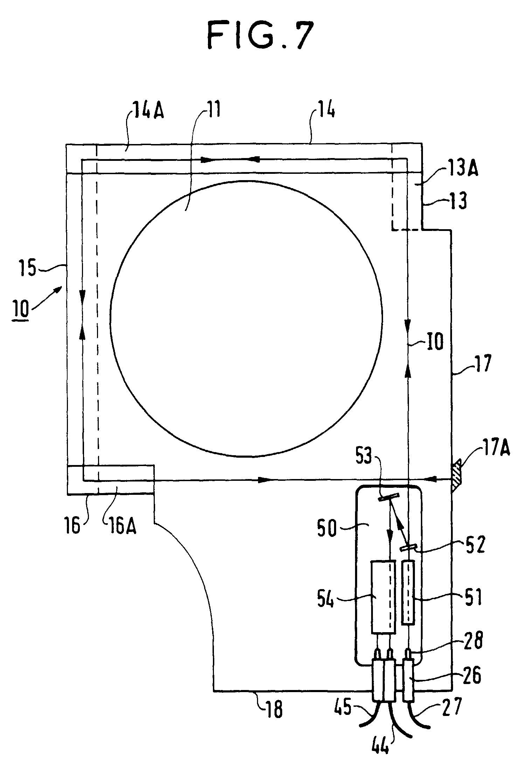

La figure 7 représente une autre variante de réalisation de l'invention, dans laquelle la lumière fait un double passage dans l'anneau autour de l'ouverture 11, ce qui double la sensibilité en raison du phénomène bien connu de non réciprocité de l'effet Faraday par rapport au sens de passage de la lumière.

Les éléments communs à la figure 7 et aux figures précédentes ont reçu les mêmes numéros de référence.

L'anneau ne présente qu'une seule cavité 50 dans laquelle sont logés tous les éléments optiques. Tout d'abord, la cavité 50 contient un polariseur 51 orienté perpendiculairement au bord biseauté 14. Le faisceau de lumière lo, qui pénètre dans la cavité par une ouverture contenant un embout 26 à fibre optique 27 et lentille 28, traverse un polariseur 51 et, après avoir traversé une lame semi-réfléchissante 52, quitte la cavité 50 et fait un tour autour du trou 11 en se réfléchissant successivement sur les bords 14, 15 et 16; la lumière se réfléchit ensuite sur le bord 17, qui a reçu localement un traitement réfléchissant 17A, et fait un second tour autour du trou 11, dans le sens opposé au précédent; elle pénètre à nouveau dans la cavité 50, se réfléchit sur la lame 52 et, après une réflexion sur un miroir de renvoi 53, pénètre dans un analyseur constitué d'un bloc massif de spath d'Islande 54. Comme indiqué précédemment en référence à la figure 1, le faisceau ordinaire et le faisceau extraordinaire, en sortie de l'analyseur, quittent le dispositif optique par des fibres 44 et 45. Tous les éléments optiques contenus dans la cavité sont fixés au moyen de colle souple.

La disposition précitée permet de doubler la sensibilité de l'appareil, mais au prix d'un appareillage légèrement plus complexe.

L'anneau de verre usiné a l'avantage, par rapport aux dispostitifs de mesure de courant à fibres optiques, de n'être, une fois usiné, sous aucune contrainte. On peut donc imaginer de l'utiliser comme milieu sensible pour plusieurs capteurs et traiter ainsi le coûteux problème de la redondance.

La redondance existe, en effet, parce que l'on soupçonne la faiblesse d'un ou plusieurs éléments d'une chaîne de mesure.

Dans le cas d'un capteur à fibres optiques, il sera nécessaire de faire redondance sur pratiquement tout (électronique, source lumineuse, fibre de transport), mais les éléments très stables comme les polariseurs en spath monobloc et l'anneau de verre seront unitaires.

On pourra ainsi, pour effectuer des redondances, disposer dans chaque cavité de multiples embouts de fibres nécessaires au nombre de capteurs désirés et faire traverser l'anneau, le polariseur et l'analyseur par plusieurs faisceaux lumineux de sources indépendantes.

## Revendications

1. Dispositif optique à anneau de verre ou autre matériau transparent pour la mesure de l'intensité électrique d'un courant parcourant un conducteur, comprenant un anneau monobloc (10) muni d'une ouverture (11) pour le passage dudit conducteur et des surfaces biseautées (13A, 14A, 15A, 16A) pour permettre à un faisceau lumineux entrant dans l'anneau par un bord donné (20A) d'effectuer au moins un tour complet autour de l'ouverture (11) avant de ressortir à l'extérieur de l'anneau, le dispositif comprenant en outre un polariseur (23), un analyseur (24) et des embouts de fibres optiques (32, 33), caractérisé en ce que le polariseur (23), l'analyseur (24) et les embouts de fibres optiques (32, 33) sont supportés et fixés dans une ou plusieurs cavités (20, 21) usinées dans l'anneau lui-même par l'intermédiaire d'une colle souple qui n'est pas traversée par le faisceau lumineux.

2. Dispositif optique selon la revendication 1 caractérisé en ce que la ou les cavités (20, 21) emprisonnent un gaz sec et sont fermées de manière étanche par des couvercles (20C, 21C).

3. Dispositif selon l'une des revendications 1 et 2, caractérisé en ce que les surfaces biseautées (13A, 14A, 15A, 16A) sont équipées de coupelles fermées (22) de manière étanche emprisonnant un gaz sec.

4. Dispositif selon l'une des revendications 1 à 3, caractérisé en ce que la cavité (20) contenant le polariseur (23) communique avec une ouverture dans laquelle est logé un embout (26) contenant une fibre optique (27) terminée par une lentille (28).

5. Dispositif selon l'une des revendications 1 à 5, caractérisé en ce que la cavité (21) contenant l'analyseur (24) communique avec deux ouvertures dans lesquelles sont logés deux embouts (32, 33) contenant deux fibres optiques terminées chacune par une lentille (34, 35).

6. Dispositif selon l'une des revendications 1 à 5, caractérisé en ce que la cavité (21) contenant l'analyseur (24) communique avec une ouverture dans laquelle est logé un embout (43) contenant deux fibres optiques (44, 45) sans lentilles.

7. Dispositif selon l'une des revendications 1 à 6, caractérisé en ce que l'un (17) des bords de l'anneau possède une zone (17A) munie d'un traitement réfléchissant permettant à la lumière d'effectuer deux tours en sens opposés autour de l'ouverture, l'anneau possédant une seule cavité (50) à l'intérieur de laquelle sont logés le polariseur (51) et l'analyseur (54), la lumière étant amenée par au moins une fibre optique (27) et quittant l'analyseur par au moins deux fibres optiques (44, 45)

8. Dispositif selon l'une des revendications 1 à 7, caractérisé en ce que le même anneau, le même polariseur et le même analyseur sont parcourus par plusieurs faisceaux de lumière indépendants pour obtenir plusieurs mesures simultanées et indépendants avec le même dispositif.

## Patentansprüche

1. Optische Vorrichtung mit einem Ring aus Glas oder einem anderem transparenten Material für die Messung der elektrischen Stärke eines Stromes, der durch einen Leiter fließt, welche einen Ring (10) aus einem Stück umfaßt, der mit einer Öffnung (11) für den Durchgang des Leiters und abgeschrägte Flächen (13A, 14A, 15A, 16A) versehen ist, um zu gestatten, daß ein Lichtbündel, das durch einen gegebenen Rand (20A) in den Ring eintritt, wenigstens einen vollständigen Umlauf um die Öffnung (11) ausführt, bevor es wieder zum Äußeren des Rings austritt, wobei die Vorrichtung außerdem einen Polarisator (23), einen Analysator (24) und Ansätze von optischen Fasern (32, 33) umfaßt, dadurch gekennzeichnet, daß der Polarisator (23), der Analysator (24) und die Ansätze von optischen Fasern (32, 33) in einer oder mehreren Vertiefungen (20, 21), die im Ring selbst eingearbeitet sind, mittels eines elastischen Klebstoffs getragen werden und befestigt sind, durch den das Lichtbündel nicht hindurchgeht.

2. Optische Vorrichtung nach Anspruch 1, dadurch gekennzeichnet, daß die Vertiefung oder Vertiefungen (20, 21) ein trockenes Gas einschließen und durch Abdeckungen (20C, 21C) dicht verschlossen sind.

3. Vorrichtung nach einem der Ansprüche 1 und 2, dadurch gekennzeichnet, daß die abgeschrägten Flächen (13A, 14A, 15A, 16A) mit dicht verschlossenen Schalen (22) ausgestattet sind, wobei sie ein trockenes Gas einschließen.

4. Vorrichtung nach einem der Ansprüche 1 bis 3, dadurch gekennzeichnet, daß die Vertiefung (20), die den Polarisator (23) enthält, mit einer Öffnung in Verbindung steht, in der ein Ansatz (26) untergebracht ist, der eine in einer Linse (28) endende optische Faser (27) beinhaltet.

**5.** Vorrichtung nach einem der Ansprüche 1 bis 5, dadurch gekennzeichnet, daß die Vertiefung (21), die den Analysator (24) enthält, mit zwei Öffnungen in Verbindung steht, in denen zwei Ansätze (32, 33) untergebracht sind, die zwei jeweils in einer Linse (34, 35) endende optische Fasern beinhalten.

**6.** Vorrichtung nach einem der Ansprüche 1 bis 5, dadurch gekennzeichnet, daß die Vertiefung (21), die den Analysator (24) enthält, mit einer Öffnung in Verbindung steht, in der ein Ansatz (43) untergebracht ist, der zwei optische Fasern (44, 45) ohne Linsen beinhaltet.

**7.** Vorrichtung nach einem der Ansprüche 1 bis 6, dadurch gekennzeichnet, daß der eine (17) der Ränder des Rings eine Zone (17A) besitzt, die mit einer Reflexionsbehandlung versehen ist, die gestattet, daß das Licht zwei Umläufe in entgegengesetzten Richtungen um die Öffnung herum ausführt, wobei der Ring eine einzige Vertiefung (50) besitzt, in deren Innerem der Polarisator (51) und der Analysator (54) untergebracht sind, wobei das Licht durch wenigstens eine optische Faser (27) zugeführt wird und den Analysator durch wenigstens zwei optische Fasern (44, 45) verläßt.

**8.** Vorrichtung nach einem der Ansprüche 1 bis 7, dadurch gekennzeichnet, daß derselbe Ring, derselbe Polarisator und derselbe Analysator von mehreren unabhängigen Lichtbündeln durchlaufen werden, um mehrere gleichzeitige und unabhängige Messungen mit derselben Vorrichtung zu erhalten.

**Claims**

**1.** An optical device having a ring of glass or of some other transparent material and serving to measure an electric current flowing along a conductor, said device including a one-piece ring (10) provided with an opening (11) through which said conductor can pass, and with bevelled surfaces (13A, 14A, 15A, 16A) to enable a light beam entering the ring via a given edge (20A) to make at least one full turn around the opening (11) before it leaves the ring, the device further including a polarizer (23), an analyzer (24), and optical-fiber end-pieces (32, 33), said device being characterized in that the polarizer (23), the analyzer (24), and the optical-fiber end-pieces (32, 33) are supported and fixed by means of a flexible glue in one or more cavities (20, 21) machined in the ring itself, the light beam not passing through the glue.

**2.** An optical device according to claim 1, characterized in that the one or more cavities (20, 21) contain a dry gas and are closed in gastight manner by covers (20C, 21C).

**3.** A device according to claim 1 or 2, characterized in that the bevelled surfaces (13A, 14A, 15A, 16A) are provided with caps (22) closed in gastight manner and containing a dry gas.

**4.** A device according to any one of claims 1 to 3, characterized in that the cavity (20) containing the polarizer (23) communicates with an opening which receives an end-piece (26) containing an optical fiber (27) terminated by a lens (28).

**5.** A device according to any one of claims 1 to 5, characterized in that the cavity (21) containing the analyzer (24) communicates with two openings which receive two end-pieces (32, 33) containing respective optical fibers, each of which is terminated by a lens (34, 35).

**6.** A device according to any one of claims 1 to 5, characterized in that the cavity (21) containing the analyzer (24) communicates with an opening which receives an end-piece (43) containing two optical fibers (44, 45) without lenses.

**7.** A device according to any one of claims 1 to 6, characterized in that one edge (17) of the ring has a zone (17A) that is treated to make it reflective, enabling the light to make two turns in opposite directions around the opening, the ring having a single cavity (50) that houses the polarizer (51) and the analyzer (54), the light being fed in via at least one optical fiber (27) and leaving the analyzer via at least two optical fibers (44, 45).

**8.** A device according to any one of claims 1 to 7, characterized in that a plurality of independent light beams are caused to pass through the same ring, the same polarizer, and the same analyzer so as to obtain a plurality of simultaneous and independent measurements with the same device.

FIG.1

FIG.3

FIG.2

FIG.4

# FIG.5

# FIG.6

EP 0 613 017 B1

# FIG.7